# EUROPÄISCHE PATENTSCHRIFT

(11) **EP 1 087 420 B1**
(45) Veröffentlichungstag und Bekanntmachung des Hinweises auf die Patenterteilung: **15.06.2005**
(21) Anmeldenummer: 00118942.2
(22) Anmeldetag: 01.09.2000
(51) Int. Cl.: H01J 37/04, H01J 37/26

(54) **Teilchenoptisches Beleuchtungs-und Abbildungssystem mit einer Kondensor-Objektiv-Einfeldlinse sowie Verfahren dazu**
Device for particle-optical illumination and imaging comprising a single field condensor-ojective lens and method of operation
Dispositif d'optique corpusculaire pour l'illumination et l'imagerie comprenant une lentille condenseur-objectif à champ unique et procédé de son utilisation

(30) Priorität: 22.09.1999 DE 19945344
(43) Veröffentlichungstag der Anmeldung: 28.03.2001
(73) Patentinhaber: Carl Zeiss NTS GmbH, 73446 Oberkochen (DE)
(72) Erfinder: Benner, Gerd, Dr., 73434 Aalen (DE)
(74) Vertreter: Gnatzig, Klaus

(56) Entgegenhaltungen:
- EP-A- 0 352 552
- US-A- 4 306 149
- US-A- 5 373 158

## Beschreibung

Die Erfindung betrifft ein teilchenoptisches Beleuchtungs- und Abbildungssystem, insbesondere für Transmissionselektronenmikroskope, mit einer Kondensor-Objektiv-Einfeldlinse.

Moderne Elektronenmikroskope sind meistens mit einer sogenannten Kondensor-Objektiv-Einfeldlinse (nachfolgend auch KOE-Linse) nach Riecke und Ruska ausgestattet, wie diese beispielsweise aus der DE-PS 875555 bekannt ist. Kondensor-Objektiv-Einfeldlinsen unterscheiden sich von konventionellen Objektiven dadurch, daß das Präparat in der Mitte des Polschuhspaltes angeordnet wird. Durch die Anordnung des Präparates im Magnetfeldmaximum resultieren gegenüber konventionellen Objektiven reduzierte Bildfehlerkoeffizienten. Außerdem ist die Realisierung von euzentrischen Goniometern und Stabschleusen wesentlich vereinfacht und es steht gegenüber konventionellen Objektiven ein größerer Bauraum für eine Präparatkippung und zum Anordnen von Detektoren, beispielsweise für vom Präparat emittierte Röntgenstrahlung oder für die Detektierung der zurückgestreuten Elektronen zur Verfügung. Außerdem bieten Kondensor-Objektiv-Einfeldlinsen die Möglichkeit, für Punktanalyse und für den Rasterbetrieb (sogenannter STEM-Betrieb) mit der Kondensor-Objektiv-Einfeldlinse sehr kleine Elektronensonden zu realisieren.

Bei den Beleuchtungseinrichtungen für Kondensor-Objektiv-Einfeldlinsen ist man bisher davon ausgegangen, daß im TEM Betrieb eine Abbildung des Cross-Overs der Teilchenquelle in die hintere Brennebene der Kondensor-Objektiv-Einfeldlinse zwingend erforderlich ist, um eine störende schiefe Präparatausleuchtung in außerachsialen Bereichen zu vermeiden. Ein entsprechendes Beleuchtungssystem, das mit lediglich zwei Kondensorlinsen auskommt, ist beispielsweise aus der US-A 3 560 781 bekannt. Um hier die bei unterschiedlich hohen Vergrößerungen erforderlichen unterschiedlichen Beleuchtungsaperturen zu ermöglichen, sind die Polschuhe der der Teilchenquelle unmittelbar nachfolgenden Kondensorlinse austauschbar, um unterschiedliche Abbildungsmaßstäbe für die mit der ersten Kondensorlinse erzielte Abbildung des Cross-Overs der Teilchenquelle zu erreichen. Die zweite Kondensorlinse wird stets mit der selben festen Erregung betrieben, damit stets das von der ersten Kondensorlinse erzeugte Cross-Over Bild in die beleuchtungsseitige Brennebene der Kondensor-Objektiv-Einfeldlinse abgebildet ist. Das hier vorgeschlagene Auswechseln der Polschuhe ist jedoch wegen der erforderlichen Präzision in der Praxis für ein Seriengerät nicht praktikabel.

In der US-A 3 560 781 wird weiterhin bereits vorgeschlagen, alternativ zum Auswechseln der Polschuhe der ersten Kondensorlinse die Erregung beider Kondensorlinsen zur Einstellung unterschiedlicher Beleuchtungsaperturen zu variieren. Auch bei einem derartigen Betrieb des Beleuchtungssystems ist jedoch die Größe des auf dem Präparat ausgeleuchteten Feldes ausschließlich durch die Größe der Kondensorblende bestimmt. Eine Änderung der Feldgröße ist daher nur über ein mechanisches Auswechseln der Kondensorblende möglich.

Aus der DE-C 28 22 242 ist eine sogenannte Twin-Objektivlinse bekannt, bei der kondensorseitig im Eisenkreis ein weiterer Linsenspalt vorgesehen ist. Mit Hilfe dieser fest erregten Hilfslinse wird die Kondensorblende in die kondensorseitige Brennebene der Kondensor-Objektiv-Einfeldlinse abgebildet. Bei diesem System ist durch Variation der Erregung der zweiten Kondensorlinse die Beleuchtungsapertur variierbar. Nachteilig ist jedoch, daß im STEM-Betrieb das Feld der Hilfslinse durch eine zusätzliche Spule kompensiert werden muß.

Aus der US-A 4 633 085 ist ein weiteres Beleuchtungssystem bekannt, dessen Funktion weitgehend der Funktion des Beleuchtungssystems der DE-C 28 22 242 entspricht. In der US 4 633 085 wird lediglich die Hilfslinse durch eine unmittelbar vor dem Objektiv angeordnete Schnorchellinse realisiert.

Obwohl die Beleuchtungssyteme der DE-A 28 22 242 und US-A 4 633 085 jeweils drei Kondensorlinsen aufweisen, gestatten diese Systeme keine unabhängige Einstellung sowohl des ausgeleuchteten Feldes als auch der Beleuchtungsapertur.

Aus der US-A 5 013 913 ist ein Beleuchtungssystem bekannt, bei dem die Beleuchtungsapertur und das ausgeleuchtete Feld unabhängig voneinander einstellbar sind. Dieses System enthält drei Kondensorlinsen, die den Cross-Over der Teilchenquelle mit variierbarer Vergrößerung stets in die quellenseitige Brennebene der Kondensor-Objektiv-Einfeldlinse abbilden. Die Größe des Cross-Over Bildes definiert dabei die Beleuchtungsapertur. Die Größe des Leuchtfeldes wird bestimmt durch die Größe der Kondensorblende, die durch elektronenoptische Auswahl einer geeigneten Blende aus einer Mehrlochblende variierbar ist. Dieses Beleuchtungssystem ermöglicht stets eine optimale Ausleuchtung des Präparates; dieser Vorteil wird jedoch durch einen relativ komplexen Aufbau erkauft.

Es ist das Ziel der vorliegenden Erfindung, ein einfaches Beleuchtungssystem für eine Kondensor-Objektiv-Einfeldlinse zu schaffen, das eine kontinuierliche Variation der Leuchtfeldgröße ermöglicht und bei dem mit einer Verkleinerung des Leuchtfeldes eine Vergrößerung der Beleuchtungsapertur einhergeht. Ein weiteres Ziel der Erfindung ist es, ein Betriebsverfahren für eine solches Beleuchtungssystem anzugeben, bei dem mit einer Verkleinerung des Leuchtfeldes eine Vergrößerung der Beleuchtungsapertur einhergeht.

Dieses Ziel wird erfindungsgemäß durch ein teilchenoptisches Beleuchtungs- und Abbildungssystem mit den Merkmalen des Anspruches 1 und ein Verfahren mit den Merkmalen des Anspruchs 11 gelöst. Vorteilhafte Ausgestaltungen ergeben sich aus den Merkmalen der abhängigen Ansprüche.

Das erfindungsgemäße teilchenoptische Beleuchtungs- und Abbildungssystem weist eine Kondensor-Objektiv-Einfeldlinse, zwei zwischen einer Teilchenquelle und der Kondensor-Objektiv-Einfeldlinse angeordnete Kondensorlinsen und ein der Kondensor-Objektiv-Einfeldlinse nachgeschaltetes mehrlinsiges Abbildungssystem auf Im TEM-Betrieb wird zur Variation des ausgeleuchteten Feldes in der Präparatebene ausschließlich die Erregung der der Teilchenquelle benachbarten Kondensorlinse variiert. Die Erregung der der Kondensor-Objektiv-Einfeldlinse benachbarten Kondensorlinse ist im TEM-Betrieb unabhängig von der Größe des eingestellten Leuchtfeldes fest.

Als TEM-Betrieb werden dabei solche Beleuchtungsbedingungen verstanden, bei denen entweder der Durchmesser des ausgeleuchteten Feldes in der Präparatebene ≥ 0,5 µm ist oder die Beleuchtungsapertur ≤ 5mrad ist.

Erfindungsgemäß wurde erkannt, daß sich mit einem nur zwei Kondensorlinsen aufweisenden Beleuchtungssystem auch bei einer Kondensor-Objektiv-Einfeldlinse alleinig durch Variation der Erregung der quellenseitigen Kondensorlinse die im TEM-Betrieb erforderlichen Aperturen und Größen des ausgeleuchteten Feldes realisieren lassen. Das erfindungsgemäße Beleuchtungs- und Abbildungssystem weist deshalb vorzugsweise genau zwei Kondensorlinsen auf.

Bei Einstellung eines maximalen Leuchtfelddurchmessers sollte die quellenseitige Kondensorlinse relativ stark erregt werden, so daß sie den Cross-Over der Teilchenquelle etwa 20 - 50-fach verkleinert abbildet. Die Erregung der objektivseitigen Kondensorlinse sollte dann so eingestellt sein, daß diese zweite Kondensorlinse den von der quellenseitigen Kondensorlinse erzeugten Cross-Over etwa im Maßstab 1:1 in die kondensorseitige Brennebene der Kondensor-Objektiv-Einfeldlinse abbildet. Beim maximalen Leuchtfelddurchmesser ergibt sich dadurch eine achsenparallele, kohärente Beleuchtung des Präparates, so daß bei dieser Einstellung keine schiefe Ausleuchtung der achsenfernen Bereiche auftritt.

Zur Einstellung kleinerer Leuchtfelddurchmesser wird zweckmäßig die Erregung der teilchenquellenseitigen Kondensorlinse reduziert, so daß das von der quellenseitigen Kondensorlinse erzeugte Bild des Cross-Overs entlang der optischen Achse in Richtung auf den objektivseitigen Kondensor zuwandert. Das kleinste Leuchtfeld wird dann erreicht, wenn beide Kondensorlinsen gemeinsam den Cross-Over der Teilchenquelle in die zur Präparatebene bezüglich der Kondensor-Objektiv-Einfeldlinse konjugierte Ebene zwischen der zweiten Kondensorlinse und der Kondensor-Objektiv-Einfeldlinse abbilden. Die Kondensor-Objektiv-Einfeldlinse bildet dann diesen Zwischen-Cross-Over auf das Präparat ab. Bei kleineren Leuchtfelddurchmessern resultiert dann zwar eine schiefe Ausleuchtung der außerachsialen Bereiche des Präparates. Da jedoch die schiefe Ausleuchtung mit kleiner werdenden Leuchtfelddurchmesser zunimmt, wirkt sich dieses nicht sehr störend aus.

Damit mit dem zweistufigen Kondensor der gesamte im TEM-Betrieb üblicherweise benötigte Bereich verschiedener Felddurchmesser realisierbar ist, sollte der feste Abbildungsmaßstab der objektivseitigen Kondensorlinse größer als 1:3 sein, vorzugsweise zwischen 1:1 und 1:3 (bei maximalem Leuchtfelddurchmesser maximale Verkleinerung des Cross-Over-Bildes um 1/3 durch die zweite Kondensorlinse) liegen.

Um bei kleinen Leuchfelddurchmessern die Beleuchtungsapertur zu begrenzen, sollte in der quellenseitigen Brennebene der Kondensor-Objektiv-Einfeldlinse eine Vorfeldblende vorgesehen sein. Diese Vorfeldblende sollte auswechselbar sein, damit bei einer Spotbeleuchtung größere Beleuchtungsaperturen erzielbar sind.

Mit den oben beschriebenen Strahlengängen liegen die kleinsten erreichbaren Leuchtfelddurchmesser im Bereich von 1 µm. Für die Einstellung kleinerer Leuchtfelddurchmesser werden beide Kondensorlinsen (im sogenannten Spot- oder STEM-Mode) als Zoom betrieben, wobei beide Kondensorlinsen stets den Cross-Over der Teilchenquelle in die kondensorseitige Eingangsbildebene der Kondensor-Objektiv-Einfeldlinse abgebildet. Die Kondensor-Objektiv-Einfeldlinse bildet dann das dort entstehende Zwischenbild des Cross-Overs der Teilchenquelle noch einmal verkleinert auf das Präparat ab. Durch unterschiedliche Erregungen beider Kondensorlinsen läßt sich dann die Spotgröße variieren.

Bei dem erfindungsgemäßen Beleuchtungs- und Abbildungssystem ist demzufolge für die objektivseitige Kondensorlinse im TEM-Betrieb ein einziger Erregungswert einstellbar.

Nachfolgend werden Einzelheiten der Erfindung anhand des in den Figuren dargestellten Ausführungsbeispiels beschrieben. Im einzelnen zeigen:
- Fig. 1: einen Schnitt entlang der optischen Achse durch ein Elektronenmikroskop gemäß der Erfindung;
- Fig. 2: die Strahlengänge im Beleuchtungsstrahlengang beim Elektronenmikroskop aus Figur 1 im TEM-Betrieb; und
- Fig. 3: die Strahlengänge im Beleuchtungsstrahlengang des Elektronenmikroskops aus Figur 1 im STEM-Betrieb.

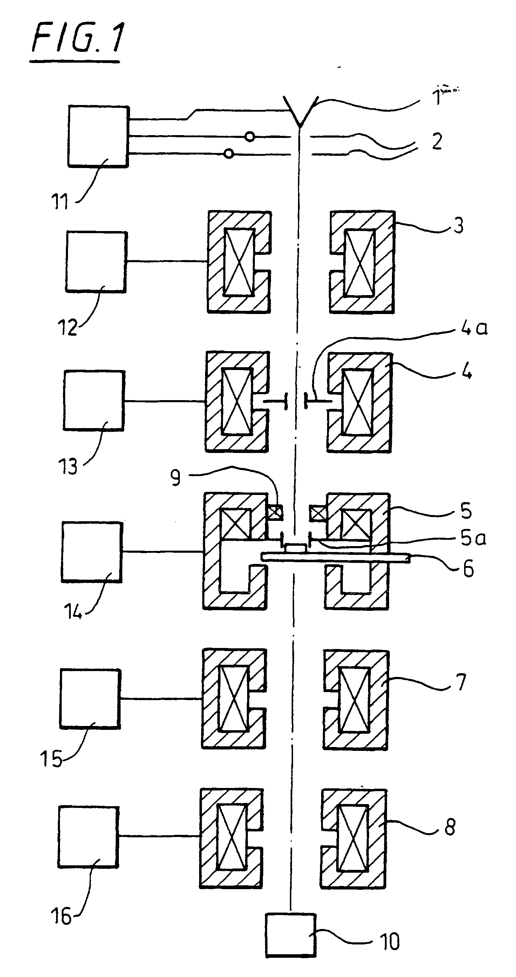

Das Elektronenmikroskop in Figur 1 weist eine Teilchenquelle (1) mit einer nachfolgenden Beschleunigungsstufe (2) für die aus der Quelle (1) austretenden Elektronen auf. Für die beleuchtungsseitige Strahlformung des aus der Quelle (1) austretenden Elektronenstrahls ist ein aus zwei Magnetlinsen (3, 4) bestehendes Kondensorsystem vorgesehen. Den beiden Kondensorlinsen (3, 4) folgt die Kondensor-Objektiv-Einfeldlinse (5) nach. Der Präparathalter (6) ist in der Kondensor-Objektiv-Einfeldlinse (5) auf der Höhe des Polschuhspaltes und damit im Maximum des Magnetfeldes der Kondensor-Objektiv-Einfeldlinse angeordnet. Etwas quellenseitig des Polschuhspaltes der Kondensor-Objektiv-Einfeldlinse sind weitere Spulen (9) vorgesehen, die als Ablenksystem im STEM-Betrieb dienen. In der kondensorseitigen Brennebene der Kondensor-Objekiv-Einfeldlinse (5) ist eine mechanisch auswechselbar gestaltete Vorfeldblende (5a) angeordnet. Aufgrund der kurzen Brennweite der Kondensor-Objekiv-Einfeldlinse (5) von nur 3 -4 mm entspricht die Lage der Vorfeldblende (5a) ebenfalls in etwa der Lage des Polschuhspaltes der Kondensor-Objekiv-Einfeldlinse.

Der Kondensor-Objektiv-Einfeldlinse (5) folgt ein mehrstufiges System aus Magnetlinsen (7, 8), die zur vergrößerten Abbildung eines Präparates auf einen Detektor (10) dienen. Von dem Abbildungssystem sind in der Figur 1 lediglich zwei Linsen (7, 8) dargestellt; in der Regel wird dieses Abbildungssystem jedoch aus drei oder vier Magnetlinsen bestehen.

Mit (11 - 16) sind in der Figur 1 die für die Versorgung der einzelnen elektronenoptischen Komponenten erforderlichen Steuer- und Versorgungseinheiten bezeichnet. Es handelt sich dabei um Strom- und Spannungsquellen, die über einen nicht dargestellten Computer gesteuert werden.

Auf der Höhe des Polschuhspaltes der objektivseitigen Kondensorlinse (4) kann wahlweise eine Kondensoraperturblende (4a) eingeführt werden. Diese Kondensoraperturblende (4a) ist lediglich im EDX-Betrieb erforderlich. Denn im EDX-Betrieb sollte die Vorfeldblende aus dem Strahlengang entfernt werden, da andernfalls von der Vorfeldblende ausgelöste Störstrahlung das eigentliche Meßsignal überdecken würde. In diesem Fall dient die Kondensoraperturblende (4a) zur Beschränkung der Beleuchtungsapertur.

Die Kondensor-Objektiv-Einfeldlinse (5) hat üblicherweise unabhängig von der eingestellten Vergrößerung der Abbildung eine fest vorgegebene Erregung, so daß die Bildfehler minimal sind. Demzufolge liefert auch die Stromversorgung (14) für die Kondensor-Objektiv-Einfeldlinse (5) sowohl im TEM-Mode als auch im STEM-Mode stets den selben festen Erregungsstrom. Lediglich um eine optimal kleine Elektronensonde in der Ebene des Präparates im STEM-Mode zu erzielen, kann die Erregung der Kondensor-Objektiv-Einfeldlinse geringfügig abgeändert werden.

Im TEM-Betrieb erfolgt die Änderung des Abbildungsmaßstabes des Präparates auf den Detektor (10) durch Änderung der Erregung der der Kondensorobjektivlinse (5) nachgeschalteten Abbildungsstufen (7, 8). Zur Anpassung des auf dem Präparat ausgeleuchteten Feldes an das von den Abbildungsstufen (7, 8) abgebildeten Feldes des Präparates ist im Beleuchtungsstrahlengang die Erregung der ersten, der Quelle (1) nachfolgenden Kondensorlinse (3) variierbar. Die Erregung der zweiten, dem Objektiv (5) benachbarten Kondensorlinse (4) bleibt hingegen im TEM-Betrieb fest und wird nur im STEM-Betrieb variiert.

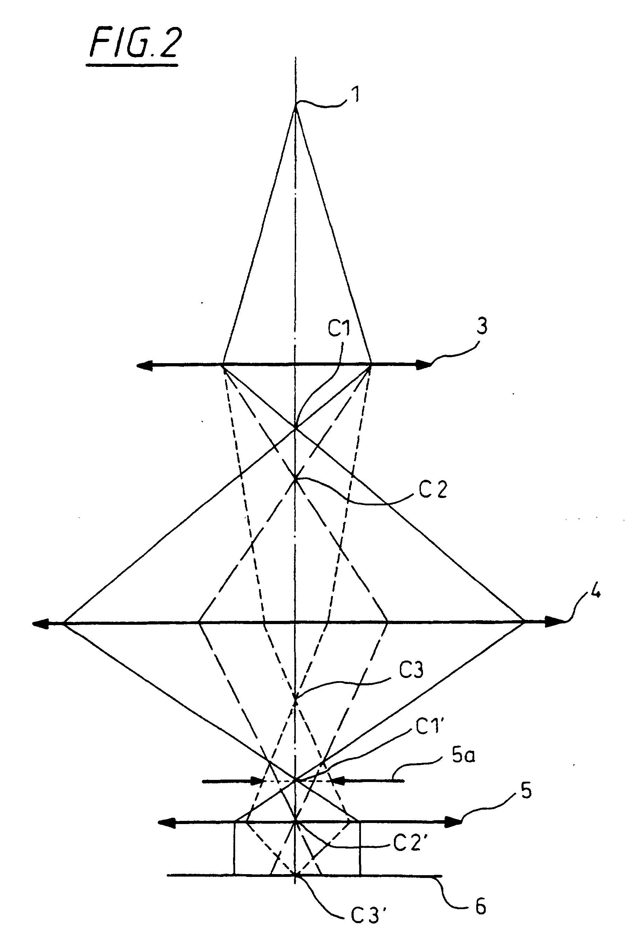

Die im Beleuchtungsstrahlengang zur Ausleuchtung unterschiedlich großer Leuchtfelder in der Ebene des Präparates (6) jeweils realisierten Strahlengänge sind in der Figur 2 dargestellt. Zur Einstellung des maximalen Leuchtfeldes, also eines Leuchtfeldes mit maximalem Durchmesser, wird die quellenseitige Kondensorlinse (3) stark erregt, so daß diese Kondensorlinse ein stark verkleinertes, reelles Bild (C1) des Cross-Overs der Teilchenquelle erzeugt. Der Abbildungsmaßstab dieser verkleinerten Cross-Over Abbildung beträgt etwa 1:20 bis 1:50. Die objektivseitige Kondensorlinse (4) bildet das von der ersten Kondensorlinse (3) erzeugte verkleinerte Bild (C1) des Cross-Overs reell in die quellenseitige Brennebene der Kondensor-Objektiv-Einfeldlinse ab, so daß dort ein weiteres Zwischenbild (C1') des Cross-Overs entsteht. Der Abbildungsmaßstab bei dieser zweiten Cross-Over Abbildung beträgt dabei etwa 1:1. Aufgrund der Wirkung des Vorfeldes der Kondensor-Objektiv-Einfeldlinse (5) erfolgt die Ausleuchtung in der Präparatebene (6) wie bei Kondensor-Objektiv-Einfeldlinsen üblich durch achsenparallele Strahlen.

Für die Einstellung kleinerer Leuchtfelder wird lediglich die Erregung der quellenseitigen Kondensorlinse (3) reduziert, während die Erregung der objektivseitigen Kondensorlinse (2) und natürlich die Erregung der Kondensor-Objektiv-Einfeldlinse fest bleibt. Das von der quellenseitigen Kondensorlinse (3) erzeugte Cross-Over Bild (C2) verschiebt sich dabei je nach Abschwächung der Kondensorlinse (3) in Richtung auf die objektivseitige Kondensorlinse (4) mit der Folge, daß sich auch das von der objektivseitigen Kondensorlinse (4) erzeugte Abbild (C2') des Cross-Over Bildes (C2) in Richtung auf die Kondensor-Objektiv-Einfeldlinse (5) verschiebt. In der Präparatebene (6) resultiert daraus die Ausleuchtung eines kleineren Leuchtfeldes mit divergenten Teilchenstrahlen.

Das minimale Leuchtfeld wird erreicht, wenn die Erregung der quellenseitigen Kondensorlinse (3) soweit abgeschwächt ist, daß beide Kondensorlinsen (3, 4) gemeinsam ein nur geringfügig verkleinertes Bild (C3) des Cross-Overs der Teilchenquelle und zwar in der bezüglich der Kondensor-Objektiv-Einfeldlinse (5) zur Präparatebene (6) konjugierten Ebene erzeugt wird. Diese Ebene des Cross-Over Bildes (C3) ist die eingangsseitige Bildebene der Kondensor-Objektiv-Einfeldlinse (5), so daß die Kondensor-Objektiv-Einfeldlinse (5) ein verkleinertes Bild (C3') des Cross-Over Bildes (C3) in der Präparatebene (6) erzeugt.

Wie man der Figur 2 entnehmen kann, werden beim erfindungsgemäßen Beleuchtungs- und Abbildungssystem beim TEM-Betrieb stets zwei Cross-Over Bilder erzeugt, wobei das zweite Cross-Over Bild (C1', C2', C3') zwischen der quellenseitigen Brennebene der Kondensor-Objektiv-Einfeldlinse und der Präparatebene entsteht. Die Erzeugung der zweiten Cross-Over Bilder in der Brennebene der Kondensor-Objektiv-Einfeldlinse und in der Präparatebene der Kondensor-Objektiv-Einfeldlinse (5) stellen dabei jeweils die Grenzeinstellungen bei maximalem bzw. minimalem Leuchtfelddurchmesser dar.

Wie der Figur 2 weiterhin entnehmbar ist, wirkt die in der quellenseitigen Brennebene der Kondensor-Objektiv-Einfeldlinse (5) angeordnete Vorfeldblende (5a) lediglich bei sehr kleinen Leuchtfelddurchmessern aperturbegrenzend. Der Öffnungsdurchmesser der Vorfeldblende sollte je nach Brennweite der Kondensor-Objektiv-Einfeldlinse (5) dabei so gewählt werden, daß die maximale Beleuchtungsapertur bei minimalem Leuchtfeld etwa 2,5 bis 3mrad beträgt. Bei größeren Leuchtfelddurchmessern fällt die Beleuchtungsapertur ab und ist im Extremfall der achsenparallelen Ausleuchtung minimal mit einem Wert von unter 0,1mrad. Bei Einstellung auf minimalem Leuchtfelddurchmesser bewirken die beiden Kondensorlinsen (3, 4) gemeinsam nur eine recht schwach verkleinerte Abbildung der Teilchenquelle (1) in den Cross-Over (C3). Dennoch lassen sich durch die nachfolgende Abbildung dieses Cross-Over Bildes durch die Kondensor-Objektiv-Einfeldlinse minimale Leuchtfelder mit einem Durchmessen von etwa 1 µm erreichen.

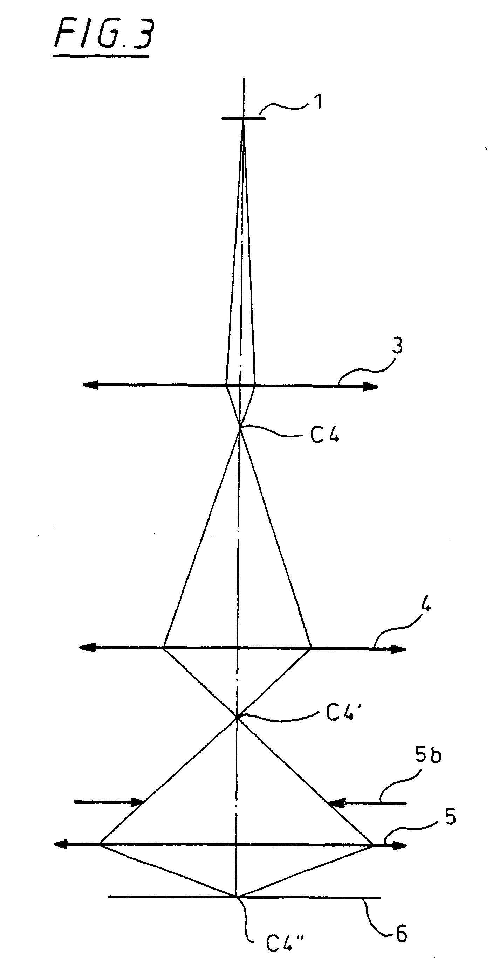

Im STEM-Mode werden beide Kondensorlinsen als Zoom-Stystem betrieben. In der Figur 3 ist der Strahlengang bei kleinst möglichem Spotdurchmesser dargestellt. In diesem Fall wird die quellenseitige Kondensorlinse (3) auf ihre maximale Erregung eingestellt, die der Erregung bei maximalem Leuchtfelddurchmesser im TEM-Mode entspricht. Die quellenseitige Kondensorlinse erzeugt demzufolge ein 1:30fach verkleinertes Cross-Over Bild (C4) der Teilchenquelle (1). Die objektivseitige Kondensorlinse (4) wird in diesem Fall so stark erregt, daß sie das von der quellenseitigen Kondensorlinse (3) erzeugte Cross-Over Bild (C4) etwa im Abbildungsmaßstab 1:5 in die zur Ebene des Präparates (6) konjugierte Ebene, der eingangsseitigen Bildebene der Kondensor-Objektiv-Einfeldlinse (5) abbildet. In dieser konjugierten Ebene entsteht demzufolge ein weiterer Zwischen-Cross-Over (C4'). Dieser weitere Zwischen-Cross-Over (C4') wird von der Kondensor-Objektiv-Einfeldlinse in die Ebene des Präparates (6) abgebildet, so daß dort ein weiteres Cross-Over Bild (C4'') entsteht. Bei unveränderter Erregung der Kondensor-Objektiv-Einfeldlinse lassen sich auf diese Weise minimale Sondengrößen von ca. 7nm erzeugen. Durch geringfügige Änderung der Erregung der Kondensor-Objektiv-Einfeldlinse (5) läßt sich eine minimale Spotsize von 2,5nm im Durchmesser erreichen.

Sollen größere Spotdurchmesser eingestellt werden, die zwischen den Minimalwerten von etwa 7nm bzw. 2,5nm und 1µm betragen, so kann die Erregung der beiden Kondensorlinsen (3, 4) so verändert werden, daß sie ein stets die Teilchenquelle (1) in die quellenseitige Bildebene der Kondensor-Objektiv-Einfeldlinse (5) abbildendes Zoomsystem bilden.

Um bei Spotbeleuchtung, also im STEM-Mode, einen maximalen Sondenstrom zu erzielen, ist gegenüber dem TEM-Mode ein Auswechseln der Vorfeldblende auf einen Durchmesser von etwa 100-200µm erforderlich, woraus Beleuchtungsaperturen im Bereich 5 - 20 mrad resultieren. Für einen Nachweis der vom Präparat emittierten Röntgenstrahlung (EDX-Betrieb) kann entweder die Vorfeldblende aus Beryllium bestehen oder in der Nähe der Hauptebene der objektivseitigen Kondensorlinse (4) eine Kondensorblende (4a) vorgesehen sein.

## Patentansprüche

1. Teilchenoptisches Beleuchtungs- und Abbildungssystem mit einer Kondensor-Objektiv-Einfeldlinse (5), zwei zwischen einer Teilchenquelle (1) und der Kondensor-Objektiv-Einfeldlinse vorgesehenen Kondensorlinsen (3, 4) und einem der Kondensor-Objektiv-Einfeldlinse nachgeschalteten mehrlinsigen Abbildungssystem (7, 8), **gekennzeichnet durch** mittel, die zur Variation des ausgeleuchteten Bereiches im TEM-Mode ausschließlich die Erregung der der Teilchenquelle (1) benachbarten Kondensorlinse (3) variieren und die Erregung der der Kondensor-Objektiv-Einfeldlinse (5) benachbarten Kondensorlinse (4) konstant halten.

2. Teilchenoptisches Beleuchtungs- und Abbildungssystem nach Anspruch 1, wobei genau zwei Kondensorlinsen (3, 4) vorgesehen sind.

3. Teilchenoptisches Beleuchtungs- und Abbildungssystem nach Anspruch 1 oder 2, wobei die Erregung der der Kondensor-Objektiv-Einfeldlinse (5) benachbarten Kondensorlinse (4) konstant so gewählt ist, daß der bei maximaler Erregung der der Teilchenquelle (1) benachbarten Kondensorlinse (3) erzeugte Cross-Over (C1) von der zweiten Kondensorlinse (4) in die quellenseitige Brennebene der Kondensor-Objektiv-Einfeldlinse (5) abgebildet ist.

4. Teilchenoptisches Beleuchtungs- und Abbildungssystem nach einem der Ansprüche 1 - 3, wobei der Abbildungsmaßstab der der Kondensor-Objektiv-Einfeldlinse (5) benachbarten Kondensorlinse (4) größer als 1:3 ist.

5. Teilchenoptisches Beleuchtungs- und Abbildungssystem nach einem der Ansprüche 1 - 4, wobei in der quellenseitigen Brennebene der Kondensor-Objektiv-Einfeldlinse (5) eine Vorfeldblende (5a) vorgesehen ist.

6. Teilchenoptisches Beleuchtungs- und Abbildungssystem nach Anspruch 5, wobei die Vorfeldblende (5a) auswechselbar ist.

7. Teilchenoptisches Beleuchtungs- und Abbildungssystem nach einem der Ansprüche 1 - 6, wobei eine Aperturblende (4a) im Bereich der Hauptebene der der Kondensor-Objektiv-Einfeldlinse (5) benachbarten Kondensorlinse (4) vorgesehen ist.

8. Teilchenoptisches Beleuchtungs- und Abbildungssystem nach einem der Ansprüche 3 - 7, wobei bei maximaler Erregung der der Teilchenquelle (1) benachbarten Kondensorlinse (3) die Teilchenquelle (1) mit einem Abbildungsmaßstab kleiner 1:20 von der quellenseitigen Kondensorlinse (3) verkleinert abgebildet ist.

9. Teilchenoptisches Beleuchtungs- und Abbildungssystem nach einem der Ansprüche 1 - 8, wobei zur Erzeugung von Leuchtfeldern mit einem Durchmesser kleiner 0,5µm und Aperturen größer 5mrad die Erregung beider Kondensorlinsen (3, 4) variiert wird, so daß die Teilchenquelle (1) über eine reelle oder virtuelle Zwischenabbildung in die quellenseitige Bildebene der Kondensor-Objektiv-Einfeldlinse (5) abgebildet ist.

10. Teilchenoptisches Beleuchtungs- und Abbildungssystem nach einem der Ansprüche 1 - 8, wobei im TEM-Mode unabhängig von der Größe des Leuchfeldes jeweils zwei Zwischenbilder der Teilchenquelle (1) entstehen, wobei die zweiten Zwischenbilder (C1', C2', C3') je nach Größe des auszuleuchtenden Feldes zwischen der quellenseitigen Brennebene der Kondensor-Objektiv-Einfeldlinse (5) und der Präparatebene (6) liegen.

11. Verfahren zum Betrieb eines teilchenoptischen Beleuchtungs- und Abbildungssystems mit einer Kondensor-Objektiv-Einfeldlinse (5), zwei zwischen einer Teilchenquelle (1) und der Kondensor-Objektiv-Einfeldlinse vorgesehenen Kondensorlinsen (3, 4) und einem der Kondensor-Objektiv-Einfeldlinse nachgeschalteten mehrlinsigen Abbildungssystem (7, 8) **dadurch gekennzeichnet, dass** zur Variation des ausgeleuchteten Bereiches im TEM-Mode ausschließlich die Erregung der der Teilchenquelle (1) benachbarten Kondensorlinse (3) variiert wird und die Erregung der der Kondensor-Objektiv-Einfeldlinse (5) benachbarten Kondensorlinse (4) konstant gehalten wird.

12. Verfahren nach Anspruch 11, wobei die Erregung der der Kondensor-Objektiv-Einfeldlinse (5) benachbarten Kondensorlinse (4) bei einer solchen Erregung konstant gehalten wird, dass der bei maximaler Erregung der der Teilchenquelle (1) benachbarten Kondensorlinse (3) erzeugte Cross-Over (C1) von der zweiten Kondensorlinse (4) in die quellenseitige Brennebene der Kondensor-Objektiv-Einfeldlinse (5) abgebildet wird.

13. Verfahren nach Anspruch 11 oder 12, wobei die der Kondensor-Objektiv-Einfeldlinse (5) benachbarte Kondensorlinse (4) so erregt wird, dass der Abbildungsmaßstab der der Kondensor-Objektiv-Einfeldlinse (5) benachbarten Kondensorlinse (4) größer als 1:3 ist.

14. Verfahren nach einem der Ansprüche 11 bis 13, wobei die der Teilchenquelle (1) benachbarte Kondensorlinse (3) bei maximaler Erregung der der Teilchenquelle (1) benachbarten Kondensorlinse (3) die Teilchenquelle (1) mit einem Abbildungsmaßstab kleiner 1:20 verkleinert abgebildet.

## Claims

1. Particle-optical illuminating and imaging system having a single-field condenser-objective lens (5), two condenser lenses (3, 4), provided between a particle source (1) and the single-field condenser-objective lens, and a multilens imaging system (7, 8) downstream of the single-field condenser-objective lens, **characterized by** means which, for the purpose of varying the illuminated region in TEM mode, vary only the excitation of the condenser lens (3) adjacent to the particle source (1) and keep constant the excitation of the condenser lens (4) adjacent to the single-field condenser-objective lens (5).

2. Particle-optical illuminating and imaging system according to Claim 1, in which exactly two condenser lenses (3, 4) are provided.

3. Particle-optical illuminating and imaging system according to Claim 1 or 2, in which the excitation of the condenser lens (4) adjacent to the single-field condenser-objective lens (5) is selected to be constant such that the crossover (C1) generated in the case of maximum excitation of the condenser lens (3) adjacent to the particle source (1) is imaged by the second condenser lens (4) into the source-side focal plane of the single-field condenser-objective lens (5).

4. Particle-optical illuminating and imaging system according to one of Claims 1-3, in which the linear magnification of the condenser lens (4) adjacent to the single-field condenser-objective lens (5) is greater than 1:3.

5. Particle-optical illuminating and imaging system according to one of Claims 1-4, in which a front field stop (5a) is provided in the source-side focal plane of the single-field condenser-objective lens (5).

6. Particle-optical illuminating and imaging system according to Claim 5, in which the front field stop (5a) can be interchanged.

7. Particle-optical illuminating and imaging system according to one of Claims 1-6, in which an aperture stop (4a) is provided in the region of the main plane of the condenser lens (4) adjacent to the single-field condenser-objective lens (5).

8. Particle-optical illuminating and imaging system according to one of Claims 3-7, in which in the case of maximum excitation of the condenser lens (3) adjacent to the particle source (1) the particle source (1) is imaged in a reduced fashion by the source-side condenser lens (3) with a linear magnification of less than 1:20.

9. Particle-optical illuminating and imaging system according to one of Claims 1-8, in which for the purpose of generating illuminated fields with a diameter of less than 0.5 µm and apertures of greater than 5 mrad the excitation of two condenser lenses (3, 4) is varied such that the particle source (1) is imaged into the source-side image plane of the single-field condenser-objective lens (5) via a real or virtual intermediate image.

10. Particle-optical illuminating and imaging system according to one of Claims 1-8, in which two intermediate images of the particle source (1) are produced in each case in the TEM mode irrespective of the size of the illuminated field, the second intermediate images (C1', C2', C3') lying between the source-side focal plane of the single-field condenser-objective lens (5) and the specimen plane (6), depending on the size of the field to be illuminated.

11. Method for operating a particle-optical illuminating and imaging system having a single-field condenser-objective lens (5), two condenser lenses (3, 4), provided between a particle source (1) and the single-field condenser-objective lens, and the multilens imaging system (7, 8) downstream of the single-field condenser-objective lens, **characterized in that** for the purpose of varying the illuminated region in the TEM mode, only the excitation of the condenser lens (3) adjacent to the particle source (1) is varied, and the excitation of the condenser lens (4) adjacent to the single-field condenser-objective lens (5) is kept constant.

12. Method according to Claim 11, in which the excitation of the condenser lens (4) adjacent to the single-field condenser-objective lens (5) is kept constant at an excitation such that the crossover (C1) generated in the case of maximum excitation of the condenser lens (3) adjacent to the particle source (1) is imaged by the second condenser lens (4) into the source-side focal plane of the single-field condenser-objective lens (5).

13. Method according to Claim 11 or 12, in which the condenser lens (4) adjacent to the single-field condenser-objective lens (5) is excited such that the linear magnification of the condenser lens (4) adjacent to the single-field condenser-objective lens (5) is greater than 1:3.

14. Method according to one of Claims 11 to 13, in which in the case of maximum excitation of the condenser lens (3) adjacent to the particle source (1), the condenser lens (3) adjacent to the particle source (1) images the particle source (1) in a reduced fashion with a linear magnification of less than 1:20.

## Revendications

1. Dispositif d'optique corpusculaire pour l'illumination et l'imagerie comprenant une lentille condenseur-objectif à champ unique (5), deux lentilles condenseurs (3, 4) prévues entre une source de particules (1) et la lentille condenseur-objectif à champ unique et un système d'imagerie (7, 8) à plusieurs lentilles branché à la suite de la lentille condenseur-objectif à champ unique, **caractérisé par** des moyens qui, pour faire varier la zone illuminée en mode TEM, font exclusivement varier l'excitation de la lentille condenseur (3) voisine de la source de particules (1) et qui maintiennent constante l'excitation de la lentille condenseur (4) voisine de la lentille condenseur-objectif à champ unique (5).

2. Dispositif d'optique corpusculaire pour l'illumination et l'imagerie selon la revendication 1, dans lequel sont prévues exactement deux lentilles condenseurs (3, 4).

3. Dispositif d'optique corpusculaire pour l'illumination et l'imagerie selon la revendication 1 ou 2, dans lequel l'excitation de la lentille condenseur (4) voisine de la lentille condenseur-objectif à champ unique (5) est choisie constante de telle sorte que le cross-over (C1) de la deuxième lentille condenseur (4) produit lors de l'excitation maximale de la lentille condenseur (3) voisine de la source de particules (1) est représenté dans le plan focal côté source de la lentille condenseur-objectif à champ unique (5).

4. Dispositif d'optique corpusculaire pour l'illumination et l'imagerie selon l'une des revendications 1 à 3, dans lequel l'échelle de représentation de la lentille condenseur (4) voisine de la lentille condenseur-objectif à champ unique (5) est supérieure à 1:3.

5. Dispositif d'optique corpusculaire pour l'illumination et l'imagerie selon l'une des revendications 1 à 4, dans lequel un diaphragme d'avant-plan (5a) est prévu dans le plan focal côté source de la lentille condenseur-objectif à champ unique (5).

6. Dispositif d'optique corpusculaire pour l'illumination et l'imagerie selon la revendication 5, dans lequel le diaphragme d'avant-plan (5a) est interchangeable.

7. Dispositif d'optique corpusculaire pour l'illumination et l'imagerie selon l'une des revendications 1 à 6, dans lequel un diaphragme d'ouverture (4a) est prévu dans la zone du plan principal de la lentille condenseur (4) voisine de la lentille condenseur-objectif à champ unique (5).

8. Dispositif d'optique corpusculaire pour l'illumination et l'imagerie selon l'une des revendications 3 à 7, dans lequel, lors de l'excitation maximale de la lentille condenseur (3) voisine de la source de particules (1), la source de particules (1) est représentée par la lentille condenseur côté source (3) réduite avec une échelle de représentation inférieure à 1:20.

9. Dispositif d'optique corpusculaire pour l'illumination et l'imagerie selon l'une des revendications 1 à 8, dans lequel pour générer des champs lumineux ayant un diamètre inférieure à 0,5 µm et des ouvertures supérieures à 5 mrad, on fait varier l'excitation des deux lentilles condenseurs (3, 4) de telle sorte que la source de particules (1) soit représentée par une représentation intermédiaire réelle ou virtuelle dans le plan d'image côté source de la lentille condenseur-objectif à champ unique (5).

10. Dispositif d'optique corpusculaire pour l'illumination et l'imagerie selon l'une des revendications 1 à 8, dans lequel, en mode TEM et indépendamment de la taille du champ lumineux, il se produit à chaque fois deux images intermédiaires de la source de particules (1), les deuxièmes images intermédiaires (C1', C2', C3') se trouvant, suivant la taille du champ à illuminer, entre le plan focal côté source de la lentille condenseur-objectif à champ unique (5) et le plan de l'objet.

11. Procédé d'utilisation d'un dispositif d'optique corpusculaire pour l'illumination et l'imagerie comprenant une lentille condenseur-objectif à champ unique (5), deux lentilles condenseurs (3, 4) prévues entre une source de particules (1) et la lentille condenseur-objectif à champ unique et un système d'imagerie (7, 8) à plusieurs lentilles branché à la suite de la lentille condenseur-objectif à champ unique, **caractérisé en ce que**, pour faire varier la zone illuminée en mode TEM, seule est variée l'excitation de la lentille condenseur (3) voisine de la source de particules (1) et l'excitation de la lentille condenseur (4) voisine de la lentille condenseur-objectif à champ unique (5) est maintenue constante.

12. Procédé selon la revendication 11, dans lequel l'excitation de la lentille condenseur (4) voisine de la lentille condenseur-objectif à champ unique (5) est maintenue constante avec une excitation telle que le cross-over (C1) de la deuxième lentille condenseur (4) produit lors de l'excitation maximale de la lentille condenseur (3) voisine de la source de particules (1) est représenté dans le plan focal côté source de la lentille condenseur-objectif à champ unique (5).

13. Procédé selon la revendication 11 ou 12, dans lequel la lentille condenseur (4) voisine de la lentille condenseur-objectif à champ unique (5) est excitée de telle sorte que l'échelle de représentation de la lentille condenseur (4) voisine de la lentille condenseur-objectif à champ unique (5) est supérieure à 1:3.

14. Procédé selon l'une des revendications 11 à 13, dans lequel, lors de l'excitation maximale de la lentille condenseur (3) voisine de la source de particules (1), la source de particules (1) est représentée par la lentille condenseur (3) voisine de la source de particules (1) réduite avec une échelle de représentation inférieure à 1:20.
